# EUROPEAN PATENT APPLICATION

(11) **EP 4 810 170 A2**
(43) Date of publication of application: **23.09.2026**
(21) Application number: 26197657.5
(22) Date of filing: 29.10.2024
(51) Int. Cl.: B06B 1/06

(54) **CONVERTING ELEMENT AND VIBRONIC SENSOR**

(62) Document number(s) of the earlier application(s) in accordance with Art. 76 EPC: 24209550.3 / 4 739 059
(71) Applicant: Endress+Hauser SE+Co. KG, 79689 Maulburg (DE); CTS Corporation Advanced Materials and Solutions, 3490 Kvistgaard (DK)
(72) Inventor: Bauer, Harald, 79539 Lorrach (DE); Dötsch, Michael, 79736 Rickenbach (DE); Wimberger, Peter, 79650 Schopfheim (DE); Mangeot, Charles, 1817 Frederiksberg (DK); Feidenhans'l, Nikolaj Agentoft, 3000 Elsinore (DK); Lou-Moeller, Rasmus, 2000 Frederiksberg (DK); Bloch, Henrik, 3060 Espergarde (DK); Mignanelli, Laura, 79618 Rheinfelden (DE)
(74) Representative: Endress + Hauser Group Services (Deutschland) AG+Co. KG

(57) **Abstract**

The invention refers to a converting element (2) for converting between mechanical vibrations and electric signals. There are various piezoelectric elements (3) arranged in a stack and a connector (4) being a wire. At the outside (5) of the stack are grooves (6) between adjacent piezoelectric elements (3). The connector (4) is located within the grooves (6) which are filled with an electrically conductive filling material (7). The connector (4) is connected to the stack via a sintering process. The connector (4) comprises inner segments (8) located within the grooves (6) and outer segments (9) located outside of the grooves (6). The outer segments (9) are located at the outside (5) of the stack. One line of isolation (16) located on top of the outer segments (9) of the connector (4) acts as a strain relief of the connector (4). The invention further covers a vibronic sensor with a converting element (2).

## Description

The invention relates to a converting element. The invention further relates to a vibronic sensor with a converting element. The vibronic sensor serves for determining or monitoring at least one process variable, e.g. level, density or viscosity of a medium. The medium for example being a fluid, a liquid, a gas or a bulk solid.

Vibronic sensors are widely used in process and/or automation technology. The sensors comprise at least one mechanically oscillatable unit (also called vibrating element), such as, for example, a single tine, a fork or a membrane. The vibrating element is excited during operation by means of an exciter/receiving unit (also: driver or converting element) such that mechanical oscillations are executed. The exciter/receiving unit is frequently an electromechanical transducer unit in most cases comprising piezoelectric elements. The piezoelectric elements are usually disks arranged in a stack.

A design of a converting element suitable especially for the operation under higher temperatures is given by US 6,710,517 B2. Described is a stack of piezoelectric elements in the form of disks with grooves at their respective front side. Within these grooves - and due to the location within the stack - is a connector arranged that serves for the electric connection of the stack. The production of such a stack is rather cumbersome as it has to be built level by level.

An object of the invention is to provide a converting element with piezoelectric elements that can be used at higher temperature and that also addresses the topic of the electric connection.

The object is achieved by a converting element for converting between mechanical vibrations and electric signals, wherein the converting element comprises various piezoelectric elements arranged in a stack, wherein the converting element further comprises at least one connector, wherein the connector is a wire, wherein the stack of piezoelectric elements comprises at its outside grooves between adjacent piezoelectric elements, wherein the connector is located partially within the grooves, wherein at least grooves in which the connector is located are filled with an electrically conductive filling material, wherein the connector is connected to the stack of piezoelectric elements, wherein the connector comprises inner segments that are located within the grooves and outer segments that are located outside of the grooves, and wherein the outer segments are located at the outside of the stack of piezoelectric elements.

The piezoelectric elements are electrically connected by at least one connector. The connector is arranged within grooves at the outside and, thus, at the rim of the piezoelectric elements. The grooves are deep enough so that the connector reaches at least one of the electrodes that are usually provided at the front sides of the piezoelectric elements. Within the stack, the electrodes of adjacent piezoelectric elements face each other and have the same polarity. In an embodiment, each groove reaches into both piezoelectric elements between which the groove is located. In an embodiment, the front sides of the piezoelectric elements are completely covered by their respective electrodes. Hence, the grooves between neighboring piezoelectric elements allow the part of connector within them to reach the electrodes of both adjacent piezoelectric elements.

The connector is partially within the grooves and partially outside of the stack of piezoelectric elements. Thus, the connector just has to be put into contact with the grooves at the outside. This facilitates the production. For the fixation of the connector to the stack of piezoelectric elements, for example, a sintering process or a bonding process is performed. In an alternative way or additionally, a high temperature resistant adhesive is used for connecting the connector to the stack, e.g. for the bonding process. Prefarably, no soldering or welding process has to be performed. Hence, the connector which is a wire remains flexible. This is, e.g., necessary for the further handling of the converting element.

In an embodiment of the converting element, the piezoelectric elements of the stack of piezoelectric elements are essentially identical in their dimensions and/or their material. In this embodiment, the ceramic components that are polarized and, thus, used as piezoelectric elements are identical with regard to their dimension and/or to their material, This embodiment facilitates the production of the converting element.

The piezoelectric elements have preferably a form of a disk with a diameter between 5 mm and 10 mm.

The ground area of the piezoelectric elements has in an embodiment the form of a circle or of a square. In embodiment, the disks of the piezoelectric elements have closed surface or have a hole.

According to an embodiment of the converting element, the grooves have a form of a straight cut with a given length and/or a given depth. The size of the groove is at least dependent on the diameter of the wire that forms the connector. The length of the grooves is in one embodiment between 5% and 50% of the diameter of the piezoelectric elements. In an embodiment, depth and length of the grooves are identical for all grooves or at least for the grooves in which the connector is located. In a further embodiment, the depth is defined by the length accordingly.

In an embodiment, there are grooves in which the connector is located and grooves which are free from the connector. In an additional embodiment, the grooves with connector have at least one dimension (i.e. length or depth) smaller than the grooves without connector. Thus, the empty grooves are greater than the non-empty grooves. This embodiment helps to avoid a shortcut of the outer segments of the connector with electrodes of piezoelectric elements.

In one embodiment, the grooves are parallel to each other.

In an embodiment of the converting element, the various piezoelectric elements are connected to each other via a sintering process, wherein between adjacent piezoelectric elements, at least a layer of a sintering component is located.

According to an embodiment of the converting element, the sintering component comprises silver.

In an embodiment of the converting element, the filling material comprises silver.

According to an embodiment of the converting element, the filling material comprises a low temperature sintering silver. A sintering process at a lower temperature prevents an oxidation of the connector.

According to an embodiment of the converting element, only grooves in which a connector is located are filled with the electrically conductive filling material. In this embodiment, the other grooves remain empty and serve as isolators.

In an embodiment, the outer segments of the connector are mainly arranged above the grooves without connector. In an embodiment, the outer segments comprise a return point from one direction to another or - in other words - a cusp of the loop they form. This return point or cusp is preferably located above such an empty groove. This enlightens the effect of the empty grooves as separators in order to avoid a shortcut. Such a shortcut could happen due to the fact that the connector is a blank wire.

In an embodiment, the grooves with connector and the grooves without connector, i.e. being empty with respect to the connector, are arranged in an alternating way.

In an embodiment of the converting element, the piezoelectric elements are polarized, wherein the piezoelectric elements are such arranged that sides of the piezoelectric elements with same polarization are in contact with another.

In an embodiment of the converting element, the piezoelectric elements are polarized, wherein the piezoelectric elements are such arranged within the stack of piezoelectric elements that they form two sub-stacks, wherein in each sub-stack of the two sub-stacks the piezoelectric elements are such arranged that sides of the piezoelectric elements with same polarization are in contact with another, wherein at least one isolator ceramic is located between the front sides of the two sub-stacks being aligned with each other, and wherein the front sides of the two sub-stacks being aligned with each other have same polarizations.

In this embodiment, the converting element comprises a driver unit and a separate receiver unit for causing and receiving mechanical vibrations, respectively. In the corresponding sub-stacks, the piezoelectric elements are connected to each other mechanically and electrically. Each piezoelectric element comprises a side with a plus-pole and a side with a minus-pole. In one embodiment, each sub-stack comprises an even number of piezoelectric elements causing the two sub-stacks to have two ends with the same pole, preferably a minus-pole. Both sub-stacks are arranged in a way that they face each other with the same pole. Between the sub-stacks is an isolator ceramic that electrically isolates both sub-stacks from each other.

In an additional embodiment, the grooves with and without connector alternate with each other within the same sub-stack. In this embodiment, within each sub-stack a groove with connector is followed by a groove without connector that is followed by a groove with connector and so on.

According to an embodiment of the converting element, the outside of the stack of piezoelectric elements comprises a groove between each front side of the two sub-stacks being aligned with each other and the isolator ceramic. In an additional embodiment, there are two connectors and their respective last inner segments are located within the respective grooves between the front sides of the sub-stacks and the isolator ceramic in the middle.

In an embodiment of the converting element, the isolator ceramic is made with a piezoelectric ceramic, wherein the piezoelectric ceramic is preferably the material of the piezoelectric elements of the stack of piezoelectric elements. In this embodiment, the converting element comprises a set with various disks made from the same material. Some are polarized and are the piezoelectric elements. The other disk (or in another embodiment: other disks) is not polarized and serves as the isolating isolator ceramic.

According to an embodiment of the converting element, at least a region of the outside of the stack of piezoelectric elements comprising at least the grooves between the front sides of the two sub-stacks being aligned with each other and the isolator ceramic is covered by a barrier. In this embodiment, a barrier serves as an electric isolator between the front sides of the two sub-stacks that face each other.

In an embodiment, the entire outside of the stack of piezoelectric elements is covered by a barrier. In an alternative embodiment, the barrier is limited to a specific region.

In an embodiment of the converting element, the barrier comprises a layer of glass.

According to an embodiment of the converting element, the converting element comprises two connectors.

In an embodiment of the converting element, each of the two connectors is associated to one sub-stack of the two sub-stacks.

According to an embodiment of the converting element, the stack of piezoelectric elements comprises at its outside grooves between each pair of adjacent piezoelectric elements.

In an embodiment of the converting element, a number of grooves of the stack of piezoelectric elements is greater than a number of grooves in which a connector is located. In this embodiment, not all grooves house a connector. Some of them remain empty without a connector and without filling material.

According to an embodiment of the converting element, the outside of the stack of piezoelectric elements is covered by an electrically isolating protection. The electrically isolating protection is used as an electric isolator between the different components of the converting element and as a strain relief of the outer segments of the connector or the connectors.

In an embodiment of the converting element, the electrically isolating protection is a resin, being preferably an epoxy resin. In an alternative embodiment, the electrically isolating protection is a glass or a high temperature varnish or lacquer or a layer of a polytetrafluoroethylene (PTFE).

According to an embodiment of the converting element, at least one line of isolation is located in such a way on top of at least a part of the outer segments of the connector that the line of isolation acts as a strain relief of the connector. This embodiment contacts forces possibly acting on the outer segments of the connector or the connectors.

In an embodiment of the converting element, the at least one line of isolation runs essentially along the longitudinal axis of the stack of piezoelectric elements.

According to an embodiment of the converting element, two lines of isolation are located on top of at least a part of the outer segments of the connector, wherein the two lines of isolation run essentially parallel.

In an embodiment of the converting element, the two lines of isolation and the barrier form the capital letter H. This specific form is relevant for the embodiment with two sub-stacks that are especially separated by an isolator ceramic.

According to an embodiment of the converting element, the line of isolation comprises a layer of glass.

In an embodiment of the converting element, at least one isolator ceramic is located at a front side of the stack of piezoelectric elements.

According to an embodiment of the converting element, at least one isolator ceramic is located at each of two front sides of the stack of piezoelectric elements. In an additional embodiment, both front sides of the stack of piezoelectric elements have a following isolator ceramic.

According to a further embodiment of the converting element, the converting element comprises a first side and a second side, wherein the converting element comprises at least two connectors, wherein the first side and the second side comprise grooves, and wherein one of the at least two connectors is located partially within the grooves of the first side and another of the at least two connectors is located partially within the grooves of the second side. In this embodiment, there are two connectors which are located within grooves at different sides of the converting element. The expression "side" refers here, for example, to the front and back side of the stack of piezoelectric elements. This is especially in contrast to the front sides of the stack. These front sides of the stack might in this context also be called top side and bottom side of the stack. The connectors are - for example, as part of the vibronic sensor - connected with the plus-pole and minus-pole, respectively, of a voltage source.

The object is further achieved by a vibronic sensor for determining and/or monitoring at least one process variable, with at least one vibrating element and with a converting element for converting between mechanical vibrations and electric signals, wherein the converting element is embodied according to one of the preceding of following embodiments. The embodiments of the converting element also hold for the vibronic senor. Due to this, the advantages of the embodiments and their respective discussion are also valid for the sensor and are not repeated here.

According to an embodiment of the vibronic sensor, the vibrating element is a fork.

According to an embodiment of the vibronic sensor, the vibronic sensor further comprises an electronic unit, wherein the electronic unit is embodied to receive electric signals from the converting element and to submit electric signals to the converting element, wherein the converting element is such embodied that the piezoelectric elements form two sub-stacks, wherein the converting element comprises a first side and a second side, wherein the converting element comprises four connectors, wherein two connectors are associated to each sub-stack and are located at different sides of the converting element, and wherein the electronic unit receives the electric signals from the converting element and submits signals to the converting element via the four connectors is such a way that connectors located at a same side of the converting element carry electric signals of different polarity. In this embodiment, the converting element comprises two sub-stacks made of piezoelectric elements. One sub-stack serves as a sender and the other sub-stack serves as a receiver for the mechanic vibrations. Both sub-stacks have two connectors for serving as a plus-pole and a minus-pole of the electric signals. The converting element and, therefore, the two sub-stacks have a first and a second side which can, e.g., be called front and back side. In this embodiment, the connectors located at the same side carry signals of different polarity. Hence, at the first side is the plus-pole of the first sub-stack and the minus-pole of the second sub-stack. At the second side, the situation is accordingly. This is relevant with regard to the front sides of the two sub-stacks laying adjacent to another within the stack of piezoelectric elements. As the connectors are associated with different poles that change during the operation of the vibronic sensor (all signals are alternating current signals), there is less risk that a migration of the components (e.g. silver atoms) of the sintering component between the piezoelectric elements happens. Such a migration might be possible if both connectors are connected to the same pole but at different values.

The invention is discussed with the following figures. It shows:
- Fig. 1:: a cut through a schematic illustration of a vibronic sensor,
- Fig. 2:: a view at a first embodiment of the converting element,
- Fig. 3:: a view at a second embodiment of the converting element,
- Fig. 4:: a view at a third embodiment of the converting element, and
- Fig. 5:: a top view at a converting element 2.

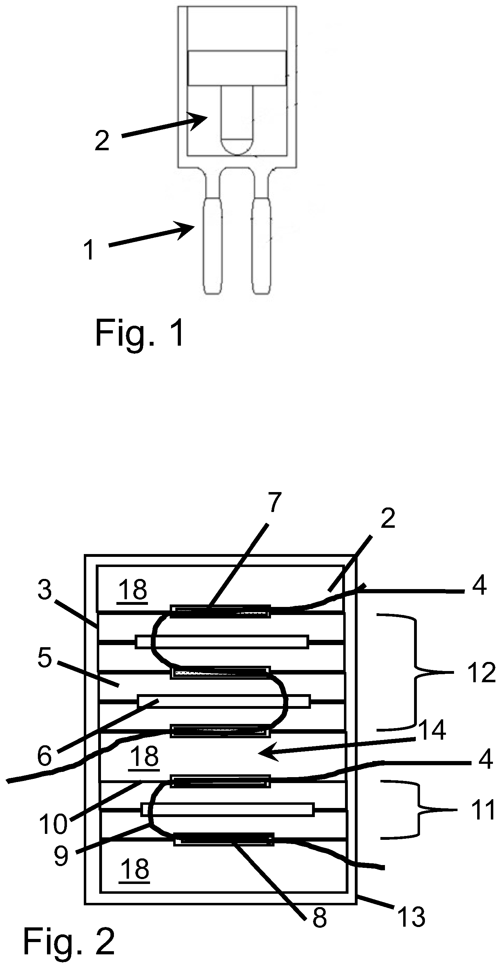

Fig. 1 shows an exemplary embodiment of the vibronic sensor.

The vibrating element 1 is given by a so-called fork comprising two tines that are connected to a membrane. The membrane is one side of a housing. The converting element 2 is located within the housing between a screw and the membrane. In the shown embodiment, a hemispherical element is arranged between the converting element 2 and the inner side of the membrane in order to improve the transfer of force between membrane and converting element 2.

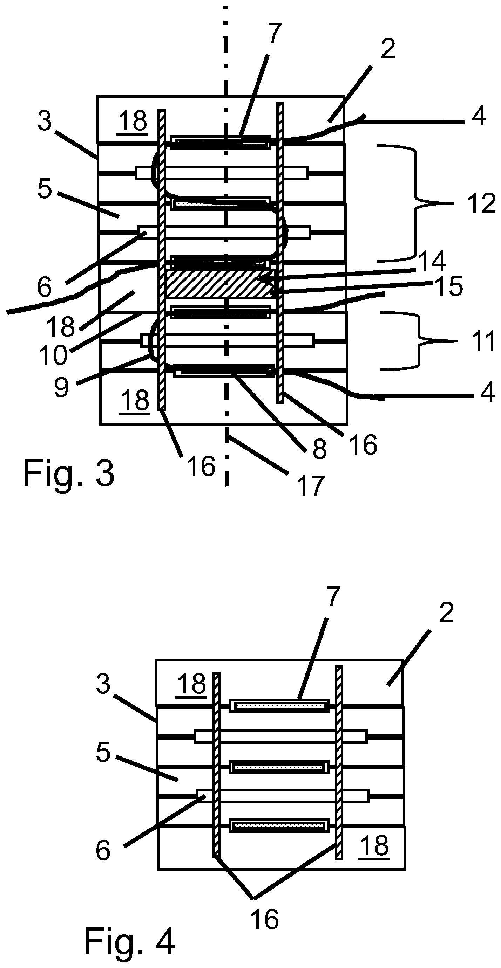

The converting element 2 comprises various piezoelectric elements 3 as will be discussed in connection with Fig. 2 and Fig. 3.

The converting element 2 is connected to an electronic unit (compare Fig. 3) that on one hand produces excitation signals and submits them to the converting element 2 and that on the other hand receives and evaluates receiving signals produced by the converting element 2. Based on the electric excitation signals, the converting element causes the vibrating element 1 to perform mechanical vibrations. As the vibrating element 1 interacts with a medium - not shown here - the vibrations are dependent on the contact with the medium or on characteristics of the medium, e.g. viscosity. Due to this, it is possible to derive from the mechanical vibrations performed by the vibrating element the process variable or to monitor changes of them. For this purpose, the converting element 2 receives mechanical vibrations of the vibrating element 1 and transforms them into electric receiving signals that are transmitted to the mentioned electronic unit. Based on amplitude, frequency or the phase of the receiving signals it is possible to evaluate the values of the process variables.

The following figures 2 and 3 show two embodiments of the converting element 2 which can be used at high temperatures, even up to 230 °C, and which consists of stacks of piezoelectric elements 3. The temperature range in which the converting element 2 can be used depends on the used materials and can even be higher.

The embodiments of Fig. 2 and Fig. 3 comprises two sub-stacks 11, 12 of piezoelectric elements 3.

In the embodiment of Fig. 4, there is just one single stack. Accordingly, the details concerning the individual sub-stacks 11, 12 can also be applied to a single stack, i.e. being a sub-stack that kind of lacks another sub-stack.

Fig. 2 shows an embodiment with six piezoelectric elements 3 and three isolator ceramics 18, all in the form of round discs. The piezoelectric elements 3 are polarized so that one front side is the positive pole and the other front side is the negative pole. For the electric contact, the piezoelectric elements 3 are covered with metallic electrodes at their front sides (not shown here as being within the stack).

The piezoelectric elements 3 are arranged in the stack in order to increase their mechanical strength and, simultaneously, their mechanical sensibility. For this purpose, they are arranged in a way so that the front sides with the same sign of polarity are in contact.

Here, the stack is divided into two sub-stacks 11, 12, whereas one sub-stack 11 serves as a receiving unit with two piezoelectric elements 3 and the other sub-stack 12 serves as a driving unit with four piezoelectric elements 3. The front sides of the two sub-stacks 11, 12 aligned with each other have same polarity.

In the shown case that the upper side of the top-most piezoelectric element has negative polarity (-), the sequence of polarities in the shown embodiment is: "-, +, -, Isolation, -, +, -, +, - ". The first three polarities "-, +, -" belong to the receiving sub-stack 11 and the other five polarities "-, +, -, +, -" belong to the driving sub-stack 12. Between both sub-stacks 11, 12, an "Isolator" is located.

The isolator ceramics 18 are located at the outer front sides of the stack of piezoelectric elements 3 and between the front sides of the two sub-stacks 11, 12 aligned with another. This middle isolator ceramic 18 separates both sub-stacks 11 ,12 electrically from each other. Additionally, the isolator ceramic 18 at least reduces the mechanic coupling between the two sub-stacks 11, 12.

The piezoelectric elements 3 and here also the isolator ceramics 18 are connected to another by a sintering process. For this step, there is a layer of a sintering component 10 between each disk of a piezoelectric ceramic, i.e. the polarized piezoelectric elements 3 and the not polarized isolator ceramics 18.

At the outside 5 of the stack of piezoelectric elements 3, there are grooves 6 being located between the individual piezoelectric elements 3, thus, reaching to both adjacent piezoelectric elements 3 and also being part of the space between them. Hence, the grooves 6 are in the shown embodiment also in contact with the electrodes of both piezoelectric elements 3.

The grooves 6 are in the shown embodiment between all disks that form the stack. This means that there are also grooves between the piezoelectric elements 3 and the isolator ceramics 18 at top, middle and bottom of the stack. Some but not all grooves are filled with a filling material 7 that contains in this embodiment a type of silver suitable for sintering processes at lower temperatures. The expression lower temperatures refers here to temperatures lower than 600 °C and preferably around 550 °C. (??? CORRECT ???)

For the electrical contact, there are two connectors 4 in the form of wires. Each connector 4 serves for the electric connection of one sub-stack 11, 12. The connectors 4 have parts or segments (called inner segments) 8 that a located within the grooves 6 and parts or segments (called outer segments) 9 between the inner segments 8 that are located outside of the grooves 6. The outer segments 9 are located at the outside 5 of the stack and the inner segments 8 are located at the rim of the stack. The inner segments 9 are fixed to the grooves 6 via a sintering process for which the filling material 7 is necessary. The filling material 7 is electrically conductive. In the shown embodiment, the filing material 7 is only within the grooves 6 that house the connectors 4. The outer segments 9 form loops. The cusp or returning point of the respective loop is located above the empty grooves 6 which reduces the risk of a shortcut of the connector 4 being a blank wire with the piezoelectric elements 3. For this purpose, the empty grooves are larger than the grooves housing the inner segments 8 of the connector 4.

The converting element 2 is covered by a electrically isolating protection 13, for example, being a resin that serves as an electric isolator and also fixes the connectors 4, especially the outer segments 9 of the connectors 4.

In the embodiment shown in Fig. 3, there is also a stack of piezoelectric elements 3.

In sum, there are nine disks made of a piezoelectric ceramic. The disks have in this embodiment the same size, i.e. same diameter and same height. Six of the disks are polarized and are the piezoelectric elements 3 for converting between electric signals and mechanical vibrations and vice versa. The other three disks are not polarized and serve as isolator ceramic 18 at the two front sides of the stack of piezoelectric elements 3 and between the two sub-stacks 11, 12 of piezoelectric elements 3. In a different embodiment, the isolator ceramics 18 have a greater height (for example up to 50% more) than the piezoelectric elements 3.

One sub-stack 11 with four piezoelectric elements 3 is the driver (or sender) and the other two piezoelectric elements 3 of the other sub-stack 12 are the receiver. The piezoelectric elements 3 in the sub-stacks 11, 12 are arranged in a way that the directly neighboring piezoelectric elements 3 have the same polarity. The front sides of the sub-stacks 11, 12 which confront each other and which are separated by the middle isolator ceramic 18 have the same polarity, too.

All piezoelectric disks 3, 18 are fixed via a sintering process. For this purpose, a layer of a sintering component 10 is located between each pair of adjacent disks. The sintering component comprises in this embodiment silver. The layer 10 also connects the electrodes - not shown here - on the surfaces of the piezoelectric elements 3. Hence, due to the layers 10 the piezoelectric elements 3, 18 are mechanically and electrically connected to each other. For the electric connection, each sub-stack 11, 12 is provided with its own connector 4 in the form of a wire. For the electric connection as well as the mechanical fixation of the connectors 4, the outer surface 5 of the stack of piezoelectric elements 3 has eight grooves 6 which are located between each pair of adjacent piezoelectric disk 3, 18. The grooves 6 are in the form of a straight trench with a given length and depth. The grooves 6 reach from the outside 5 down to a secant line of the circular disks 3, 18. The grooves are parallel to each other as they are located at the rims of the piezoelectric disks. In this embodiment, the grooves 6 that accommodate the connectors 4 are shorter and have less depth than the other grooves 6 without the connectors 4. The length of the grooves 6 is here about a third of the diameter of the piezoelectric disks 3, 18.

The connectors 4 are arranged in a meandering way with respect to the grooves 6 of the corresponding sub-stack 11, 12. Each connector 4 has an alternating sequence of segments 8, 9 located within a groove 6 and outside of the grooves 6. The outer segments 9 form a loop between the inner segments 8. Within the grooves 6 in which the inner segments 8 of the connectors 4 are located a filling material 7 comprising silver is inserted. The filing material 7 comprises a silver suitable for a low temperature sintering process that is used for fixing the inner segments 8 to the respective piezoelectric disks 3, 18.

At the outside 5 of the stack of piezoelectric elements 3, three different components form the capital letter H: At the side of the letter H are two lines of isolation 16 laid atop of the outer segments 9 of the connectors 4 and serving as a strain relief. The lines of isolation 16 are electrically non-conductive. The horizontal section of the letter H is given by a barrier 15 that covers the region 14 of the outside 5 between the two grooves 6 between the isolator ceramic 18 in the middle between the two sub-stacks 11, 12 and the respective piezoelectric elements at the end of the sub-stacks 11, 12.

The polarization of the piezoelectric elements 3 runs along the longitudinal axis 17 of the stack of piezoelectric elements 3. The two lines of isolation 16 run parallel to each other and parallel to the longitudinal axis 17. The barrier 15 runs perpendicular to the longitudinal axis 17.

The converting element 2 of the embodiment shown in Fig. 4 comprises just a single stack of piezoelectric elements 3 with isolator ceramic disks 18 at both ends. In this embodiment, the connector 4 is not depicted in order to highlight the different dimensions of the grooves 6 at the outside 5 of the stack.

In an alternating arrangement, there are smaller and larger grooves 6. The smaller grooves 6 are used to house the inner segments of the connector. The larger grooves 6 serve for avoiding shortcuts between the outer segments of the connector and the sides of the piezoelectric elements 3 the connector should not contact. The smaller grooves 6 for the inner segments of the connector are filled with the electrically conductive filling material.

Beyond the smaller grooves 6 and thus covering the greater parts of the outer segments of the connector, there are the two parallel lines of isolation 16.

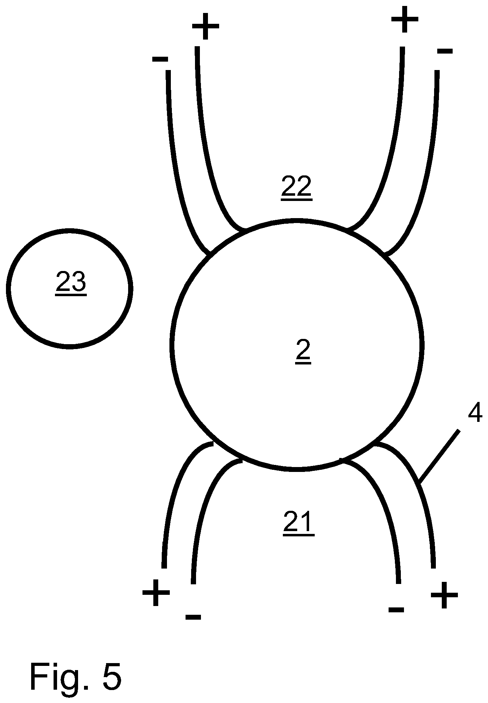

Fig. 5 gives a top view at the converting element 2.

It can be seen, that the stack of piezoelectric element 3 has a circular base area. (Possible but not shown are also piezoelectric elements with rectangular or square base areas.) The converting element 2 comprises a first side 21 and a second 22 and comprises two sub-stacks 11, 12 serving as sender and receiver for vibrating element (compare Fig. 1). Each sub-stack 11, 12 is connected by two connectors 4 to the electronic unit 23 which are located at different sides 21, 22 of the stack.

In the shown embodiment, at each side 21, 22, the inner lines belong to the connector 4 of one sub-stack and the outer lines belong to the connector 4 of the other sub-stack. The plus and minus symbols refer to the plus-pole and minus-pole of the electric signals.

Obviously, the two connectors 4 belonging to the same sub-stack are connected to different poles and the two connectors 4 belonging to the same side 21, 22 are also connected to different poles.

In a different embodiment - not shown here - the poles of the connectors 4 at the same side 21, 22 of the converting element 2 are the same.

### List of Reference Characters

- 1: Vibrating element
- 2: Converting element
- 3: Piezoelectric element
- 4: Connector
- 5: Outside of stack of piezoelectric elements
- 6: Groove
- 7: Filling material
- 8: Inner segment of connector
- 9: Outer segment of connector
- 10: Layer of a sintering component
- 11: Sub-stack the stack of piezoelectric elements
- 12: Sub-stack the stack of piezoelectric elements
- 13: Electrically isolating protection
- 14: Region of the outside of the stack of piezoelectric elements
- 15: Barrier
- 16: Line of isolation
- 17: Longitudinal axis of the stack of piezoelectric elements
- 18: Isolator ceramic
- 21: Frist side of converting element
- 22: Second side of converting element
- 23: Electronic unit

## Claims

1. Converting element (2) for converting between mechanical vibrations and electric signals,
wherein the converting element (2) comprises various piezoelectric elements (3) arranged in a stack,
wherein the converting element (2) further comprises at least one connector (4), wherein the connector (4) is a wire,
wherein the stack of piezoelectric elements (3) comprises at its outside (5) grooves (6) between adjacent piezoelectric elements (3),
wherein the connector (4) is located partially within the grooves (6),
wherein at least grooves (6) in which the connector (4) is located are filled with an electrically conductive filling material (7),
wherein the connector (4) is connected to the stack of piezoelectric elements (3), wherein the connector (4) comprises inner segments (8) that are located within the grooves (6) and outer segments (9) that are located outside of the grooves (6), and wherein the outer segments (9) are located at the outside (5) of the stack of piezoelectric elements (3),
**characterized in,**
wherein at least one line of isolation (16) is located in such a way on top of at least a part of the outer segments (9) of the connector (4) that the line of isolation (16) acts as a strain relief of the connector (4).

2. Converting element (2) according to claim 1,
wherein the piezoelectric elements (3) of the stack of piezoelectric elements (3) are essentially identical in their dimensions and/or their material.

3. Converting element (2) according to claim 1 or 2,
wherein the grooves (6) have a form of a straight cut with a given length and/or a given depth.

4. Converting element (2) according to one of claims 1 to 3,
wherein the various piezoelectric elements (3) are connected to each other via a sintering process, and
wherein between adjacent piezoelectric elements (3), at least a layer of a sintering component (10) - preferably comprising silver - is located.

5. Converting element (2) according to one of claims 1 to 4,
wherein the filling material (7) comprises a low temperature sintering silver.

6. Converting element (2) according to one of claims 1 to 5,
wherein the stack of piezoelectric elements (3) comprises at its outside (5) grooves (6) between each pair of adjacent piezoelectric elements (3).

7. Converting element (2) according to one of claims 1 to 6,
wherein a number of grooves (6) of the stack of piezoelectric elements (3) is greater than a number of grooves (6) in which a connector (4) is located.

8. Converting element (2) according to one of claims 1 to 7,
wherein the outside (5) of the stack of piezoelectric elements (3) is covered by a electrically isolating protection (13) preferably being a resin.

9. Converting element (2) according to one of claims 1 to 8,
wherein the at least one line of isolation (16) - preferably comprising a layer of glass - runs essentially along the longitudinal axis (17) of the stack of piezoelectric elements (3).

10. Converting element (2) according to one of claims 1 to 9,
wherein two lines of isolation (16) are located on top of at least a part of the outer segments (9) of the connector (4), and
wherein the two lines of isolation (16) run essentially parallel.

11. Converting element (2) according to one of claims 1 to 10,
wherein at least one isolator ceramic (18) is located at each of two front sides of the stack of piezoelectric elements (3).

12. Converting element (2) according to one of claims 1 to 11,
wherein the converting element (2) comprises a first side (21) and a second side (22),
wherein the converting element (2) comprises at least two connectors (4),
wherein the first side (21) and the second side (22) comprise grooves (6), and
wherein one of the at least two connectors (4) is located partially within the grooves (6) of the first side and another of the at least two connectors (4) is located partially within the grooves (6) of the second side (22).

13. Vibronic sensor for determining and/or monitoring at least one process variable, with at least one vibrating element (1) and with a converting element (2) for converting between mechanical vibrations and electric signals,
wherein the converting element (2) is embodied according to one of the claims 1 to 12.

14. Vibronic sensor according to claim 13,
wherein the vibronic sensor further comprises an electronic unit (23),
wherein the electronic unit (23) is embodied to receive electric signals from the converting element (2) and to submit electric signals to the converting element (2), wherein the converting element (2) is such embodied that the piezoelectric elements (3) form two sub-stacks (11, 12),
wherein the converting element (2) comprises a first side (21) and a second side (22),
wherein the converting element (2) comprises four connectors (4),
wherein two connectors (4) are associated to each sub-stack (11, 12) and are located at different sides (21, 22) of the converting element (2), and
wherein the electronic unit (23) receives the electric signals from the converting element (2) and submits signals to the converting element (2) via the four connectors (4) is such a way that connectors (4) located at a same side (21, 22) of the converting element (2) carry electric signals of different polarity.
